# EUROPEAN PATENT SPECIFICATION

(11) **EP 4 687 199 B1**
(45) Date of publication and mention of the grant of the patent: **09.12.2026**
(21) Application number: 25191670.6
(22) Date of filing: 24.07.2025
(51) Int. Cl.: H01M 50/119, H01M 10/42, H01M 10/48

(54) **BATTERY AND BATTERY MONITORING METHOD**
BATTERIE UND BATTERIEÜBERWACHUNGSVERFAHREN
BATTERIE ET PROCÉDÉ DE SURVEILLANCE DE BATTERIE

(30) Priority: 01.08.2024 KR 20240102772
(43) Date of publication of application: 04.02.2026
(73) Proprietor: SAMSUNG SDI CO., LTD., Yongin-si, Gyeonggi-do 17084 (KR)
(72) Inventor: LEE, Joohyoung, 17084 Yongin-Si (KR)
(74) Representative: Marks & Clerk LLP

(56) References cited:
- CN-A- 115 836 427
- FR-A1- 3 102 564

## Description

### FIELD

Aspects of embodiments of the present disclosure relate to a battery and a battery monitoring method.

### BACKGROUND

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

If gas is generated inside a secondary battery during the charging/discharging process of the battery, a phenomenon in which the battery heats up may occur, which may, in severe cases, lead to an explosion of the battery. In order to monitor such abnormal phenomena in the battery, techniques such as detecting gas generated inside the battery or sensing whether the battery case is swollen due to gas generation have been applied. Further, as batteries become smaller and/or thinner, it is desirable to have more precise monitoring techniques that allow batteries to quickly detect abnormal phenomena.

The above information disclosed in this Background section is for enhancement of understanding of the background of the present disclosure, and therefore, it may contain information that does not constitute related (or prior) art.

FR 3102564 A1 discloses an electrochemical accumulator (1) comprising a sensor (3) for the condition of the accumulator packaging (2) covering the surface of the packaging, in which the sensor (3) comprises a deformable film (8) and a resonant electrical circuit in the form of printed lines fixed on said film (8), the resonant circuit comprising an inductive element (4) and a capacitive element (5) of which at least one (5) of the two elements covers a monitored area of the packaging (2) such that a variation in the surface and/or thermal condition of the packaging (2) modifies the geometry of the printed lines and the frequency response of said circuit. The invention applies, for example, to electric vehicles and hybrid vehicles.

CN 115836427 A discloses a rechargeable battery pack having at least two pouch cells stacked on top of each other, in which each of the pouch cells is encapsulated in metal foils, in which the metal foils are electrically insulated from each other, and in which each of the metal foils is electrically contacted in order to measure the capacitance of a capacitor formed from the metal foils.

### SUMMARY

An object to be achieved by at least some embodiments of the present disclosure is to provide a battery and a battery monitoring method to solve the problems as described above.

These and other aspects and features of the present disclosure will be described in or will be apparent from the following description of embodiments of the present disclosure.

According to some embodiments of the present disclosure for achieving the above object, a battery includes a case formed of a conductive material, a sensing member attached to one surface of the case and including a conductor formed of a conductive material and a dielectric having at least a part thereof disposed between the case and the conductor, and a monitoring circuit electrically connected to the conductor and the case, wherein the monitoring circuit is configured to monitor whether the battery is deformed based on an amount of change in a capacitance formed between the conductor and the one surface of the case,
wherein the monitoring circuit comprises an inductor, and the inductor and the sensing member are connected, and a resonant frequency corresponding to the capacitance is generated,
wherein the monitoring circuit further comprises a controller, and
wherein the controller is configured to determine whether the battery is deformed based on an amount of change between a first frequency corresponding to a first capacitance formed at a first time point and a second frequency corresponding to a second capacitance formed at a second time point that occurs later than the first time point,
wherein the monitoring circuit further comprises an internal capacitor connected in series with the sensing member, and
wherein the internal capacitor has a predetermined third capacitance, and
the monitoring circuit is configured to monitor whether the battery is deformed based on an amount of change between a third frequency corresponding to the first capacitance and the third capacitance formed at the first time point, and a fourth frequency corresponding to the second capacitance and the third capacitance formed at the second time point,
wherein the internal capacitor is a variable capacitor, and
the third capacitance is adjusted to be equal to or greater than the first capacitance in real time.

According to some embodiments of the present disclosure, the conductor may be formed of a material having elasticity. An area of a surface of the conductor facing the case may be configured to increase as the battery swells.

According to some embodiments of the present disclosure, the thickness of the dielectric may be configured to decrease as the battery swells.

According to some embodiments of the present disclosure, the case may have a rectangular parallelepiped shape. The conductor may extend in one direction on a side surface of the rectangular parallelepiped shape. One end of the conductor may be disposed adjacent to an edge of the side surface. The other end of the conductor may be disposed to face a center location of the side surface.

According to some embodiments of the present disclosure, the case may have a cylindrical shape. The conductor may extend in one direction on a circumferential surface of the cylindrical shape. One end of the conductor may be disposed adjacent to an edge of the circumferential surface. The other end of the conductor may be disposed to face a center location of the circumferential surface.

According to some embodiments of the present disclosure, the dielectric may be an insulating film or an insulating tape. The conductor may be formed in the form of a metal pattern on the dielectric.

According to some embodiments of the present disclosure, at least a part of the case may include a stainless-steel material.

In a battery monitoring method in accordance with some embodiments of the present disclosure for achieving the above object, a battery includes a case formed of a conductive material, a sensing member attached to one surface of the case and including a conductor formed of a conductive material and a dielectric having at least a part thereof disposed between the case and the conductor, and a monitoring circuit electrically connected to the conductor and the case,
wherein the monitoring circuit comprises an inductor, and the inductor and the sensing member are connected, and a resonant frequency corresponding to the capacitance is generated,
wherein the monitoring circuit further comprises an internal capacitor connected in series with the sensing member, and
wherein the internal capacitor has a predetermined third capacitance, and
wherein the internal capacitor is a variable capacitor, and
and the method includes obtaining, by the monitoring circuit, a first frequency corresponding to a first capacitance formed between the conductor and the one surface of the case at a first time point, obtaining, by the monitoring circuit, a second frequency corresponding to a second capacitance formed between the conductor and the one surface of the case at a second time point that occurs later than the first time point, and monitoring, by the monitoring circuit, whether the battery is deformed based on an amount of change between the first frequency and the second frequency,
obtaining, by the monitoring circuit, a third frequency corresponding to the first capacitance and the third capacitance formed at the first time point;
obtaining, by the monitoring circuit, a fourth frequency corresponding to the second capacitance and the third capacitance formed at the second time point; and
monitoring, by the monitoring circuit, whether the battery is deformed based on an amount of change between the third frequency and the fourth frequency
adjusting the third capacitance to be equal to or greater than the first capacitance in real time.

According to some embodiments of the present disclosure, the case may have a rectangular parallelepiped shape. The conductor may extend in one direction on a side surface of the rectangular parallelepiped shape. One end of the conductor may be disposed adjacent to an edge of the side surface. The other end of the conductor may be disposed to face a center location of the side surface.

According to some embodiments of the present disclosure, the case may have a cylindrical shape. The conductor may extend in one direction on a circumferential surface of the cylindrical shape. One end of the conductor may be disposed adjacent to an edge of the circumferential surface. The other end of the conductor may be disposed to face a center location of the circumferential surface.

According to some embodiments of the present disclosure, the monitoring may include determining that the case is swollen if the second frequency is less than the first frequency and an amount of change between the first frequency and the second frequency is greater than a predetermined first threshold value.

According to some embodiments of the present disclosure, the monitoring may include determining that the battery is operating abnormally if the second frequency is greater than the first frequency and an amount of change between the first frequency and the second frequency is greater than a predetermined second threshold value.

According to some embodiments of the present disclosure, the conductor may be formed of a material having elasticity. An area of a surface of the conductor facing the case may increase as the battery swells.

According to some embodiments of the present disclosure, the thickness of the dielectric may decrease as the battery swells.

According to some embodiments of the present disclosure, for a battery including a case formed of a conductive material, it is possible to monitor precisely whether the battery is deformed based on the amount of change in capacitance by a battery monitoring device including one sensing member.

According to some embodiments of the present disclosure, the battery monitoring device can adjust the monitoring sensitivity of the battery monitoring device by adjusting the capacitance of the internal capacitor. Further, if the internal capacitor is formed of a variable capacitor, the monitoring sensitivity of the battery monitoring device can be adjusted in real time.

According to some embodiments of the present disclosure, the conductor included in the sensing member can be disposed in a region where the deformation rate due to the swelling of the battery is large, and accordingly, the change in capacitance due to the increase in the area of the conductor can be detected effectively.

However, aspects and features of the present disclosure are not limited to those described above, and other aspects and features not mentioned will be clearly understood by a person skilled in the art from the detailed description, described below.

At least some of the above and other features of the invention are set out in the claims.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings.
FIG. 1 is a diagram showing an example of a battery monitoring device in accordance with at least one embodiment of the present disclosure;
FIG. 2 is a diagram showing an example of a sensing member at a first time point in accordance with at least one embodiment of the present disclosure;
FIG. 3 is a diagram showing an example of a sensing member at a second time point in accordance with at least one embodiment of the present disclosure;
FIG. 4 is a diagram showing an example in which a sensing member is attached in accordance with at least one embodiment of the present disclosure;
FIG. 5 is a diagram showing an example in which a sensing member is attached in accordance with at least one embodiment of the present disclosure;
FIG. 6 is a block diagram showing the configuration of a monitoring circuit in accordance with at least one embodiment of the present disclosure;
FIG. 7 is a circuit diagram showing an example in which a battery monitoring device is implemented in accordance with at least one embodiment of the present disclosure;
FIG. 8 is a circuit diagram showing an example in which a battery monitoring device is implemented in accordance with at least one embodiment of the present disclosure;
FIG. 9 is a diagram showing an example of a battery monitoring device in accordance with a comparative example;
FIG. 10 is a circuit diagram showing an example in which a battery monitoring device is implemented in accordance with a comparative example;
FIG. 11 is a flowchart showing an example of a battery monitoring method in accordance with at least one embodiment of the present disclosure; and
FIG. 12 is a flowchart showing an example of a method for determining whether a battery is deformed in accordance with at least one embodiment of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C", "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

In the present disclosure, the sizes and relative sizes of the regions shown in the drawings may have been exaggerated for clarity of description. For example, the sizes shown in the drawings are merely for ease of understanding and are not limited thereto. Further, the same reference numerals refer to the same components throughout the specification.

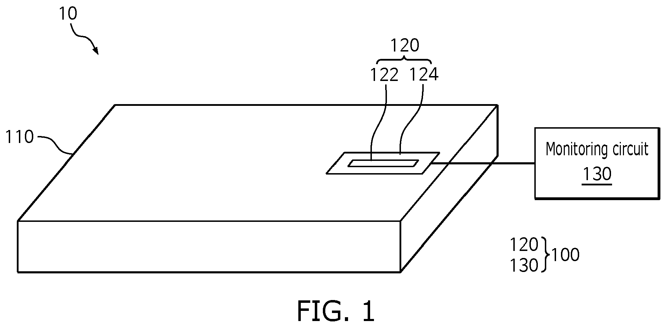

FIG. 1 is a diagram showing an example of a battery monitoring device 100 in accordance with at least one embodiment of the present disclosure. Referring to FIG. 1, a battery 10 may include a battery monitoring device 100 that monitors whether the battery 10 is deformed. The battery monitoring device 100 may include a sensing member 120 and a monitoring circuit 130 connected to the sensing member 120.

The sensing member 120 may be attached to one surface of a case 110 of the battery 10. In one embodiment, the case 110 may be formed of a conductive material. For example, the case 110 may be formed of a material such as aluminum, stainless steel, nickel-plated steel, and copper, but is not limited thereto.

The sensing member 120 may include a conductor 122 formed of a conductive material and a dielectric 124 formed of an insulating material. The conductor 122 may be formed of a material having high electrical conductivity such as copper, silver, aluminum, nickel, etc., but is not limited thereto. The dielectric 124 may be formed of various materials such as glass, rubber, and acrylic.

At least a part of the dielectric 124 may be disposed between one surface of the case 110 and the conductor 122. The dielectric 124 can insulate between the case 110 formed of a conductive material and the conductor 122, and may perform an adhesive function so that the sensing member 120 is attached to one surface of the case 110.

In one embodiment, the dielectric 124 may be in the form of an insulating film or an insulating tape, and the conductor 122 may be formed in the form of a metal pattern on the dielectric 124. For example, a metal pattern may be formed by depositing or printing the conductor 122 in a method such as photolithography, inkjet printing, or screen printing on the dielectric 124 in the form of an insulating film formed of a material such as polyimide (PI), and polyethylene terephthalate (PET).

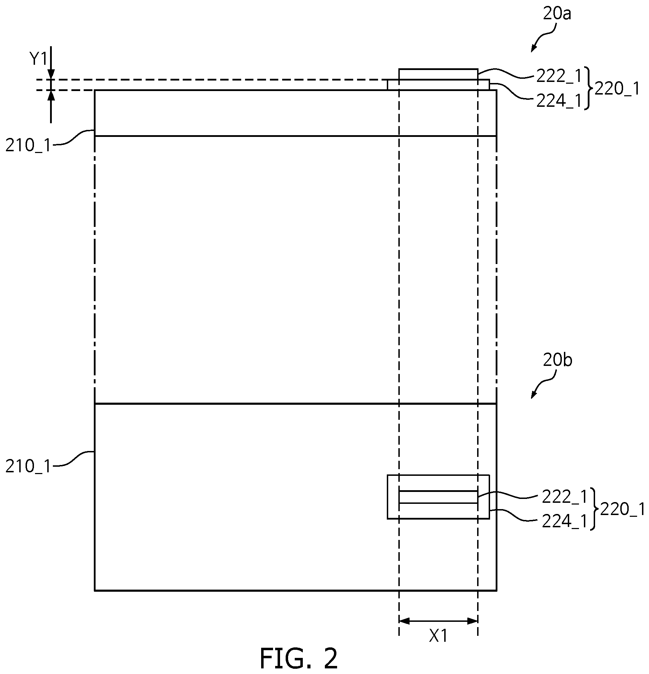

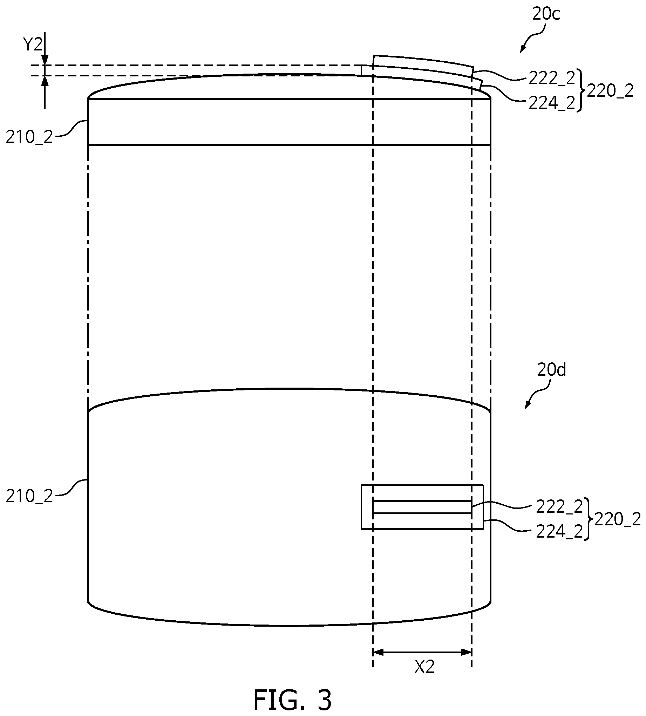

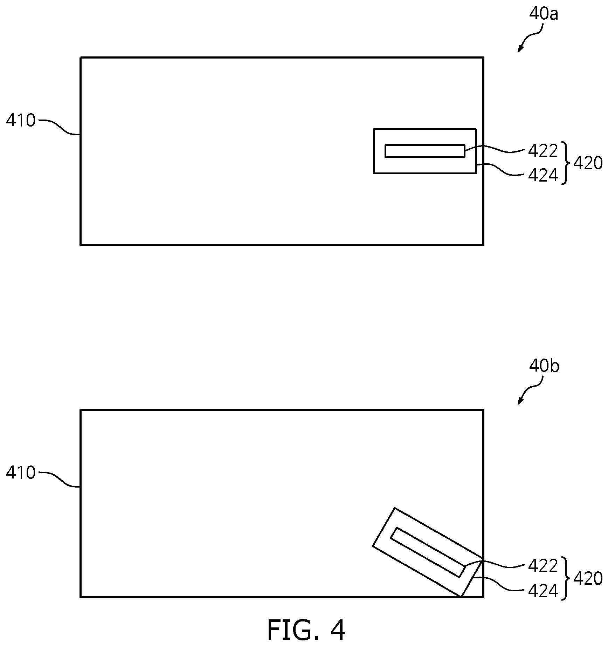

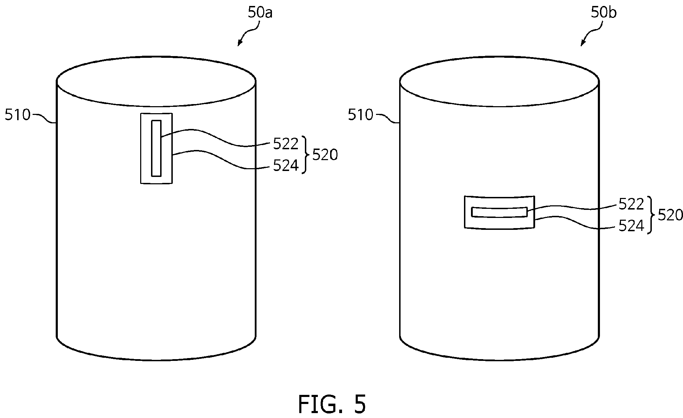

In one embodiment, the battery monitoring device 100 may monitor whether the battery 10 is deformed. Specifically, the battery monitoring device 100 may monitor whether the battery 10 is deformed based on the amount of change in capacitance due to the swelling of the case 110. To this end, the sensing member 120 may be attached to a position where the deformation rate of the case 110 is large, and accordingly, the shape of the sensing member 120 may also be deformed along with the swelling of the case 110. An example in which the shape of the sensing member 120 is deformed by the swelling of the case 110 will be described in detail later with reference to FIGS. 2 and 3. Further, an example in which the sensing member 120 is attached to the case 110 will be described in detail later with reference to FIGS. 4 and 5.

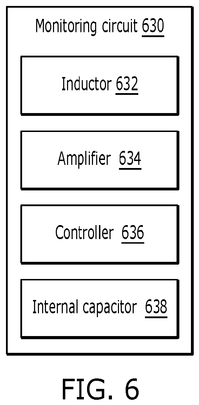

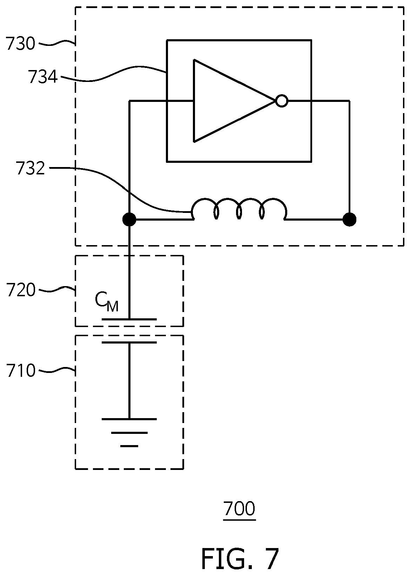

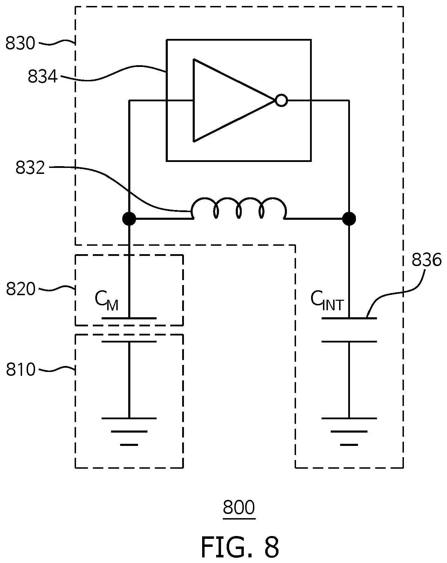

The monitoring circuit 130 may be electrically connected to the sensing member 120. In one embodiment, the monitoring circuit 130 may be connected to the sensing member 120 and form an LC resonator circuit. For example, the monitoring circuit 130 may generate a resonant frequency based on the capacitance formed between the case 110 and the sensing member 120 attached to one surface of the case 110. The monitoring circuit 130 may monitor whether the battery 10 is deformed based on the amount of change in the resonant frequency according to the amount of change in the capacitance formed between the case 110 and the sensing member 120. The specific configuration of the monitoring circuit 130 will be described in detail later with reference to FIG. 6. An example in which the monitoring circuit 130 is implemented will be described in detail later with reference to FIG. 7 and FIG. 8.

In one embodiment, the monitoring circuit 130 may be disposed outside the case 110. As a specific example, for a small battery, the monitoring circuit 130 may be included in a Protection Circuit Module (PCM) circuit formed outside the battery case 110, but is not limited thereto. Moreover, for a medium to large-sized battery, the monitoring circuit 130 may be included in a battery management system (BMS) or the like, but is not limited thereto.

In FIG. 1, the battery 10 is shown as being a prismatic battery, but is not limited thereto. For example, the battery 10 may be a battery of any shape, such as a pouch battery or a cylindrical battery, and the battery monitoring device 100 can be applied to batteries of various shapes.

FIG. 2 is a diagram showing an example of a sensing member 220_1 at a first time point in accordance with one embodiment of the present disclosure, and FIG. 3 is a diagram showing an example of a sensing member 220_2 at a second time point in accordance with one embodiment of the present disclosure.

Referring to FIG. 2, the first side view 20a may be a side view showing an example of the sensing member 220_1 at the first time point, and the first plan view 20b may be a plan view showing an example of the sensing member 220_1 at the first time point.

The sensing member 220_1 may be attached to one surface of the case 210_1 of the battery. The sensing member 220_1 may include a conductor 222_1 and a dielectric 224_1. The dielectric 224_1 may be disposed between the case 210_1 and the conductor 222_1. The dielectric 224_1 may protrude further than the conductor 222_1 so that the conductor 222_1 does not directly contact the surface of the case 210_1. Accordingly, at least a part of the dielectric 224_1 may be disposed between one surface of the case 210_1 and the conductor 222_1.

In at least one embodiment, the conductor 222_1 may be in a form extending in a first direction. For example, the width X1 of the conductor 222_1 in the first direction may be greater than the width in a second direction intersecting the first direction.

In at least one embodiment, the case 210_1 and the conductor 222_1 may be formed of a conductive material. Further, the dielectric 224_1 may be formed of an insulating material. Accordingly, a capacitance may be formed between the case 210_1 and the conductor 222_1 by a voltage applied to the conductor 222_1 through a monitoring circuit connected to the sensing member 220_1. The capacitance formed between the case 210_1 and the conductor 222_1 can be determined based on the following mathematical expression. Here, C may denote the capacitance, ε may denote the relative permittivity of the dielectric 224_1, A may denote the area of the conductor 222_1, and d may denote the vertical distance between the case 210_1 and the conductor 222_1. [Mathematical Expression 1] $C = ε \frac{A}{d}$

According to Mathematical Expression 1, it can be confirmed that the capacitance C increases as the area A of the conductor 222_1 increases. Accordingly, if the conductor 222_1 swells, the capacitance C formed between the case 210_1 and the conductor 222_1 may increase. Further, it can be confirmed that the capacitance C formed between the case 210_1 and the conductor 222_1 increases if the vertical distance between the case 210_1 and the conductor 222_1 decreases. In this case, the vertical distance between the case 210_1 and the conductor 222_1 may correspond to the thickness Y1 of the dielectric 224_1. For example, if the thickness Y1 of the dielectric 224_1 decreases, the capacitance C formed between the case 210_1 and the conductor 222_1 may increase.

Referring to FIG. 3, the second side view 20c may be a side view showing an example of the sensing member 220_2 at the second time point, and the second plan view 20d may be a plan view showing an example of the sensing member 220_2 at the second time point. Here, the second time point may refer to a time point after the first time point. Further, the first time point may refer to any time point before the battery swells, and the second time point may refer to any time point after the battery has swollen. Moreover, the second time point may refer to a time point after a certain time interval from the first time point.

According to what is shown in FIG. 3, if the case 210_2 swells due to the deformation of the battery, the sensing member 220_2 attached to the case 210_2 may be deformed together. For example, as the battery swells, the area of the surface on which the conductor 222_2 faces the case 210_2 may increase. Accordingly, the width X2 in the first direction of the conductor 222_2 may also increase. In this case, the capacitance C formed between the case 210_2 and the conductor 222_2 may increase.

Furthermore, if the case 210_2 swells due to the deformation of the battery, the area of the surface on which the dielectric 224_2 faces the case 210_2 may increase, and at the same time, the thickness Y2 of the dielectric 224_2 may decrease. In this case, the capacitance C formed between the case 210_2 and the conductor 222_2 may increase.

Accordingly, the battery monitoring device can monitor whether the battery is deformed based on the amount of change in the capacitance C formed between the case 210_2 and the conductor 222_2.

FIG. 4 is a diagram showing an example in which a sensing member 420 is attached in accordance with at least one embodiment of the present disclosure. In at least one embodiment, the sensing member 420 may be attached to a prismatic battery. A first embodiment 40a and a second embodiment 40b are plan views showing examples in which the sensing member 420 is attached to a prismatic battery.

Referring to the first embodiment 40a, the prismatic battery may include a case 410 having an approximately rectangular parallelepiped shape. The sensing member 420 may be attached to a side surface of the case 410. The sensing member 420 may be attached to the widest surface of the side surfaces surrounding the case 410, but is not limited thereto.

The sensing member 420 may include a conductor 422 and a dielectric 424 disposed between the case 410 and the conductor 422. In one embodiment, the conductor 422 may be in a form extending in a first direction. For example, the width of the conductor 422 in the first direction may be greater than the width in a second direction intersecting the first direction.

The conductor 422 may be disposed to extend in the first direction on the side surface of the case 410. In at least one embodiment, one end of the conductor 422 along the first direction may be disposed adjacent to an edge of the side surface of the case 410, and the other end of the conductor 422 along the first direction may be disposed to face the center direction of the side surface of the case 410.

Referring to the second embodiment 40b, one end of the conductor 422 along the first direction may be disposed adjacent to a corner portion of the side surface of the case 410, and the other end of the conductor 422 along the first direction may be disposed to face the center direction of the side surface of the case 410.

With this configuration, the conductor 422 can be disposed near the edge of the side surface of the case 410 where the deformation rate of the case 410 due to the swelling of the battery is large, and accordingly, the battery monitoring device can effectively detect the change in capacitance according to the increase in the area of the conductor 422.

FIG. 4 shows only an example in which the sensing member 420 is attached to a prismatic battery, but the position where the sensing member 420 is attached can be similarly applied to a pouch battery having an approximately rectangular parallelepiped shape, etc.

FIG. 5 is a diagram showing an example in which a sensing member 520 is attached in accordance with at least one embodiment of the present disclosure. In at least one embodiment, the sensing member 520 may be attached to a cylindrical battery. A third embodiment 50a and a fourth embodiment 50b are plan views showing examples in which the sensing member 520 is attached to a cylindrical battery.

Referring to the third embodiment 50a, the cylindrical battery may include a case 510 having an approximately cylindrical shape. The sensing member 520 may be attached to the circumferential surface of the case 510. The sensing member 520 may include a conductor 522 and a dielectric 524 disposed between the case 510 and the conductor 522. In at least one embodiment, the conductor 522 may be in a form extending in a first direction. For example, the width of the conductor 522 in the first direction may be greater than the width in a second direction intersecting the first direction.

The conductor 522 may be disposed to extend in the first direction along the height direction of the case 510. In at least one embodiment, one end of the conductor 522 along the first direction may be disposed adjacent to an edge of the circumferential surface of the case 510. For example, one end of the conductor 522 along the first direction may be disposed adjacent to a region where the circumferential surface of the case 510 contacts the upper surface or the lower surface of the case 510. Further, the other end of the conductor 522 along the first direction may be disposed to face the center direction of the circumferential surface of the case 510. For example, if one end of the conductor 522 along the first direction is disposed adjacent to a region where the circumferential surface of the case 510 and the upper surface of the case 510 contact, the other end of the conductor 522 along the first direction may be disposed to face the lower surface direction of the case 510. Similarly, if one end of the conductor 522 along the first direction is disposed adjacent to a region where the circumferential surface of the case 510 and the lower surface of the case 510 contact, the other end of the conductor 522 along the first direction may be disposed to face the upper surface direction of the case 510.

Referring to the fourth embodiment 50b, the conductor 522 may be disposed to extend in the first direction along the circumferential direction of the case 510. In one embodiment, the conductor 522 may be disposed in a central region of the case 510 on the basis of the height direction of the case 510, and may extend in the first direction along the circumferential direction of the case 510.

With this configuration, the conductor 522 can be disposed in a region where the deformation rate due to the swelling of the battery is large, and accordingly, the battery monitoring device can effectively detect the change in capacitance according to an increase in the area of the conductor 522.

FIG. 5 shows only an example in which the sensing member 520 is attached to a cylindrical battery, but the position where the sensing member 520 is attached can be similarly applied to a coin battery, a large-diameter battery, etc., having an approximately cylindrical shape.

FIG. 6 is a block diagram showing the configuration of a monitoring circuit 630 in accordance with at least one embodiment of the present disclosure. According to at least one embodiment, the battery monitoring device may include a sensing member attached to a case of a battery and a monitoring circuit 630 connected to the sensing member. The monitoring circuit 630 may include an inductor 632, an amplifier 634, a controller 636, and an internal capacitor 638.

The monitoring circuit 630 may be electrically connected to the sensing member. In one embodiment, the monitoring circuit 630 may be connected to the sensing member and form an LC resonator circuit. For example, the monitoring circuit 630 may apply a voltage to the sensing member. Accordingly, a capacitance may be formed between the case and the sensing member attached to the case.

The inductor 632 may be connected to the sensing member attached to the case. Accordingly, a resonant frequency corresponding to the capacitance formed between the case and the sensing member may be generated in the monitoring circuit 630. Accordingly, if the capacitance formed between the case and the sensing member changes, the resonant frequency generated in the monitoring circuit 630 may also change in response to the changed capacitance.

The amplifier 634 may be connected in parallel with the inductor 632, and provide a feedback loop that keeps the resonant frequency generated in the monitoring circuit 630 stable. An example of a circuit diagram in which the battery monitoring device is implemented will be described in detail later with reference to FIG. 7.

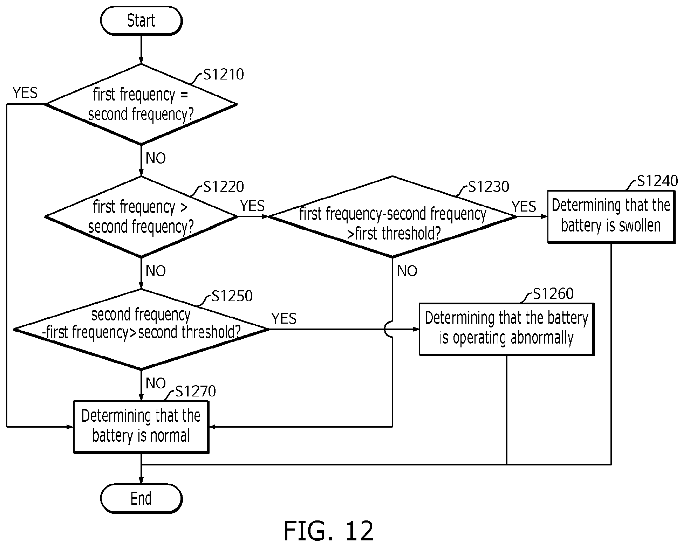

The controller 636 may determine whether the battery is deformed based on the amount of change in the resonant frequency generated in the monitoring circuit 630. For example, the controller 636 may determine that the battery is deformed if the absolute amount of change in the resonant frequency generated in the monitoring circuit 630 is greater than or equal to a predetermined threshold. Further, the controller 636 may determine that the battery is deformed if the amount of change per hour in the resonant frequency generated in the monitoring circuit 630 is greater than or equal to a predetermined threshold. An example of determining whether a battery is deformed by the controller 636 will be described in detail later with reference to FIG. 12.

The monitoring circuit 630 may further include an internal capacitor 638. The internal capacitor 638 may have a capacitance of a predetermined particular value. Accordingly, the monitoring circuit 630 may monitor whether the battery is deformed based on the capacitance formed between the case and the sensing member and the capacitance of a particular value formed in the internal capacitor 638. An example of a circuit diagram in which the battery monitoring device to which the internal capacitor 638 is applied is implemented will be described in detail later with reference to FIG. 8.

The configuration of the monitoring circuit 630 shown in FIG. 6 is merely an example, and in some embodiments, other components may be further included in addition to the components shown and some components may be omitted. If some of the above components are omitted, the functions of the omitted components may be performed by components other than the components shown.

FIG. 7 is a circuit diagram showing an example in which a battery monitoring device 700 is implemented in accordance with at least one embodiment of the present disclosure. The battery monitoring device 700 may include a sensing member 720 and a monitoring circuit 730. The monitoring circuit 730 may include an inductor 732 and an amplifier 734.

The sensing member 720 may be attached to one surface of a case 710 of a battery. Here, the case 710 may be formed of a conductive material. The sensing member 720 may include a conductor formed of a conductive material and a dielectric formed of an insulating material, and the dielectric may be disposed between the case 710 and the conductor. Accordingly, a capacitance C_{M} may be formed between the case 710 and the conductor of the sensing member 720.

The inductor 732 may be connected to the sensing member, and accordingly, a resonant frequency corresponding to the capacitance C_{M} formed between the case and the sensing member may be generated in the monitoring circuit 730. The resonant frequency generated in the monitoring circuit 730 may be determined based on the following mathematical expression. Here, f may denote the resonant frequency, L may denote the inductance of the inductor 732, and C_{M} may denote the capacitance formed between the case 710 and the sensing member 720. [Mathematical Expression 2] $f = \frac{1}{2 π \sqrt{{LC}_{M}}}$

According to Mathematical Expression 2, it can be confirmed that the resonant frequency f decreases as the capacitance C_{M} increases. Accordingly, if the capacitance C_{M} formed between the case 710 and the sensing member 720 changes due to the deformation of the battery, the resonant frequency generated in the monitoring circuit 730 may also change.

As a specific example, at a first time point before the battery swells, a first capacitance C₁ may be formed between the case 710 and the sensing member 720, and a first frequency f₁ corresponding to the first capacitance C₁ may be generated in the monitoring circuit 730. Thereafter, as the battery swells, the resonant frequency generated in the monitoring circuit 730 may change. Specifically, if the case 710 swells, the area of the conductor in the sensing member 720 attached to the case 710 may increase and the thickness of the dielectric may decrease. Accordingly, a second capacitance C₂ formed between the case 710 and the sensing member 720 at the second time point may get larger than the first capacitance C₁ formed between the case 710 and the sensing member 720 at the first time point. Accordingly, a second frequency f₂ generated in the monitoring circuit 730 at the second time point may get smaller than the first frequency f₁ generated in the monitoring circuit 730 at the first time point.

In at least one embodiment, the battery monitoring device may determine that the battery is swollen if the second frequency f₂ generated in the monitoring circuit 730 at the second time point is less than the first frequency f₁ generated in the monitoring circuit 730 at the first time point and the difference between the first frequency f₁ and the second frequency f₂ is greater than a predetermined threshold.

As another example, if the second frequency f₂ generated in the monitoring circuit 730 at the second time point is greater than the first frequency f₁ generated in the monitoring circuit 730 at the first time point and the difference between the first frequency f₁ and the second frequency f₂ is greater than a predetermined threshold, the battery monitoring device may determine that the battery is operating abnormally due to a factor other than swelling.

FIG. 8 is a circuit diagram showing an example in which a battery monitoring device 800 is implemented in accordance with at least one embodiment of the present disclosure. In FIG. 8, the configuration described in or overlapping with FIG. 7 will be omitted, and the configuration different from that of FIG. 7 will be mainly described. Referring to FIG. 8, the battery monitoring device 800 may include a sensing member 820 and a monitoring circuit 830. The monitoring circuit 830 may include an inductor 832 and an amplifier 834.

The sensing member 820 may be attached to one surface of a case 810 of a battery. The sensing member 820 may include a conductor and a dielectric, and the dielectric may be disposed between the case 810 and the conductor. Accordingly, a capacitance C_{M} may be formed between the case 810 and the conductor of the sensing member 820.

In at least one embodiment, the monitoring circuit 830 may further include an internal capacitor 836. The internal capacitor 836 may be connected in series with the sensing member 820. Further, the internal capacitor 836 may have a predetermined internal capacitance C_{INT}. The total capacitance obtained by summing the capacitance C_{M} formed between the case 810 and the sensing member 820 and the internal capacitance C_{INT} formed in the internal capacitor 836 may be determined based on the following mathematical expression. Here, C_{TOT} may denote the total capacitance, C_{M} may denote the capacitance formed between the case 810 and the sensing member 820, and C_{INT} may denote the internal capacitance formed in the internal capacitor 836. [Mathematical Expression 3] ${C}_{TOT} = \frac{{C}_{M} ⋅ {C}_{INT}}{{C}_{M} + {C}_{INT}}$

According to Mathematical Expression 3, it can be confirmed that the total capacitance C_{TOT} obtained by summing the capacitance C_{M} formed between the case 810 and the sensing member 820 and the internal capacitance C_{INT} formed in the internal capacitor 836 gets smaller than each of the capacitance C_{M} and the internal capacitance C_{INT}. Accordingly, the monitoring sensitivity of the battery monitoring device can be adjusted by adjusting the internal capacitance C_{INT}.

As a specific example, the larger the internal capacitance C_{INT}, the larger the amount of change in the total capacitance C_{TOT} according to the amount of change in the capacitance C_{M} may be. Conversely, the smaller the internal capacitance C_{INT}, the smaller the amount of change in the total capacitance C_{TOT} according to the amount of change in the capacitance C_{M} may be. Further, if the internal capacitance C_{INT} has a value less than the capacitance C_{M}, it may be rather disadvantageous to use the internal capacitor 836 for battery monitoring as the total capacitance C_{TOT} varies within a range less than the internal capacitance C_{INT}. Therefore, the internal capacitance C_{INT} formed in the internal capacitor 836 may be determined to be in a range equal to or greater than the capacitance C_{M} formed between the case 810 and the sensing member 820.

Moreover, the internal capacitor 836 may be a variable capacitor, and thus the monitoring sensitivity of the battery monitoring device may be adjusted in real time.

In at least one embodiment, if the capacitance C_{M} formed between the case 810 and the sensing member 820 changes due to the deformation of the battery, the resonant frequency generated in the monitoring circuit 830 may also change. Accordingly, the battery monitoring device can monitor the deformation of the battery.

As a specific example, at a first time point before the battery swells, a first capacitance C₁ may be formed between the case 810 and the sensing member 820, an internal capacitance C_{INT} may be formed in the internal capacitor 836, and a first frequency f₁ corresponding to the first capacitance C₁ and the internal capacitance C_{INT} may be generated in the monitoring circuit 830. Thereafter, a second capacitance C₂ formed between the case 810 and the sensing member 820 at a second time point when the battery swells may get larger than the first capacitance C₁ formed between the case 810 and the sensing member 820 at the first time point before the battery is deformed. Accordingly, a second frequency f₂ corresponding to the second capacitance C₂ and the internal capacitance C_{INT} generated in the monitoring circuit 830 at the second time point may get smaller than the first frequency f₁ corresponding to the first capacitance C₁ and the internal capacitance C_{INT} generated in the monitoring circuit 830 at the first time point.

In at least one embodiment, the battery monitoring device may determine that the battery is swollen if the second frequency f₂ generated in the monitoring circuit 830 at the second time point is less than the first frequency f₁ generated in the monitoring circuit 830 at the first time point and the difference between the first frequency f₁ and the second frequency f₂ is greater than a predetermined threshold.

As another example, if the second frequency f₂ generated in the monitoring circuit 830 at the second time point is greater than the first frequency f₁ generated in the monitoring circuit 830 at the first time point and the difference between the first frequency f₁ and the second frequency f₂ is greater than a predetermined threshold, the battery monitoring device may determine that the battery is operating abnormally due to a factor other than swelling.

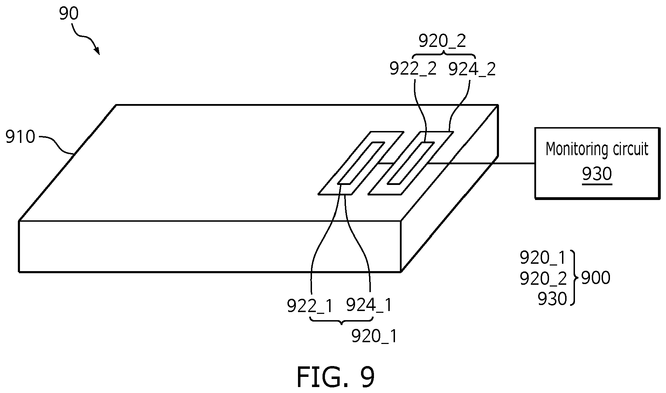

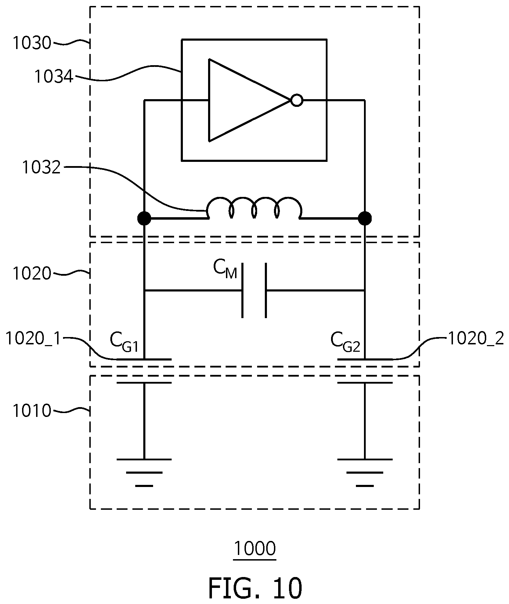

FIG. 9 is a diagram showing an example of a battery monitoring device 900 in accordance with a comparative example, and FIG. 10 is a circuit diagram showing an example in which a battery monitoring device 1000 is implemented in accordance with a comparative example. Referring to FIG. 9, a battery 90 may include a battery monitoring device 900 that monitors whether the battery 90 is deformed. The battery monitoring device 900 may include a first sensing member 920_1, a second sensing member 920_2, and a monitoring circuit 930 connected to each of the first sensing member 920_1 and the second sensing member 920_2.

In one embodiment, the first sensing member 920_1 and the second sensing member 920_2 may be attached to one surface of a case 910 of the battery 90 to be adjacent to each other. In one embodiment, the case 910 may be formed of a conductive material.

The monitoring circuit 930 may be electrically connected to the first sensing member 920_1 and the second sensing member 920_2. The monitoring circuit 930 may generate a resonant frequency based on the capacitance formed between the case 910, the first sensing member 920_1, and the second sensing member 920_2. Specifically, a first capacitance C_{G1} formed between the case 910 and the first sensing member 920_1, a second capacitance C_{G2} formed between the case 910 and the second sensing member 920_2, and a third capacitance C_{M} formed between the first sensing member 920_1 and the second sensing member 920_2 may be formed in the monitoring circuit 930.

Referring to FIG. 10, a circuit diagram in which the battery monitoring device 900 shown in FIG. 9 is implemented can be seen. The battery monitoring device 1000 may include a sensing member 1020 and a monitoring circuit 1030. The monitoring circuit 1030 may include an inductor 1032 and an amplifier 1034.

Referring to FIG. 10, if two sensing members 1020_1 and 1020_2 are connected to the monitoring circuit 1030, a first capacitance C_{G1} may be formed between the case 1010 and the first sensing member 1020_1, and a second capacitance C_{G2} may be formed between the case 1010 and the second sensing member 1020_2. Further, a third capacitance C_{M} may be formed between the first sensing member 1020_1 and the second sensing member 1020_2. In this case, the rate of change of the third capacitance C_{M} formed between the first sensing member 1020_1 and the second sensing member 1020_2 may be reduced by the first capacitance C_{G1} and the second capacitance C_{G2} formed between the case 1010 and the sensing member 1020.

In an example, for a battery including a case 1010 formed of a conductive material, the sensitivity of battery swelling detection may be reduced when a battery monitoring device including two sensing members 1020_1 and 1020_2 is used. Accordingly, for a battery including a case 1010 formed of a conductive material, it may be effective to use a battery monitoring device including one sensing member.

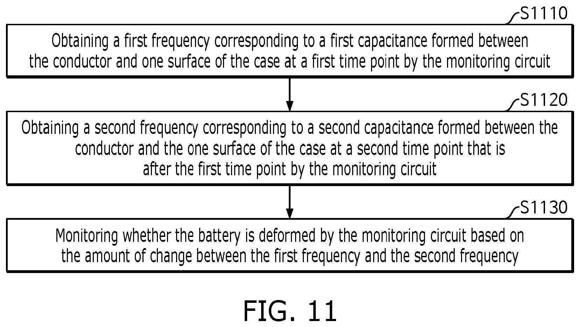

FIG. 11 is a flowchart showing an example of a battery monitoring method in accordance with at least one embodiment of the present disclosure. The battery monitoring method may begin with obtaining a first frequency corresponding to a first capacitance formed between the conductor and the one surface of the case at a first time point by the monitoring circuit (S1110). In at least one embodiment, the battery may include a case formed of a conductive material, a sensing member attached to one surface of the case and including a conductor formed of a conductive material and a dielectric having at least a part thereof disposed between the case and the conductor, and a monitoring circuit electrically connected to the conductor and the case. Here, the conductor may be formed of a material having elasticity.

In at least one embodiment, if the case has a rectangular parallelepiped shape, the conductor may extend in one direction on a side surface of the rectangular parallelepiped shape. For example, one end of the conductor may be disposed adjacent to an edge of the side surface, and the other end of the conductor may be disposed to face the center direction of the side surface.

In at least another embodiment, if the case has a cylindrical shape, the conductor may extend in one direction on a circumferential surface of the cylindrical shape. For example, one end of the conductor may be disposed adjacent to an edge of the circumferential surface, and the other end of the conductor may be disposed to face the center direction of the circumferential surface.

Then, a second frequency corresponding to a second capacitance formed between the conductor and one surface of the case at a second time point that is after the first time point may be obtained by the monitoring circuit (S1120). Here, the first time point may refer to any time point before the battery swells, and the second time point may refer to any time point after the battery has swollen. In this case, as the battery swells, the area of the surface on which the conductor faces the case may increase. Further, as the battery swells, the thickness of the dielectric may decrease.

Then, whether the battery is deformed may be monitored by the monitoring circuit based on the amount of change between the first frequency and the second frequency (S1130). In one embodiment, if the second frequency is less than the first frequency and the amount of change between the first frequency and the second frequency is greater than or equal to a predetermined first threshold, the monitoring circuit may determine that the case is swollen. Further, if the second frequency is greater than the first frequency and the amount of change between the first frequency and the second frequency is greater than or equal to a predetermined second threshold, the monitoring circuit may determine that the battery is operating abnormally.

In at least one embodiment, the monitoring circuit may include an internal capacitor connected in series with the sensing member. Here, the internal capacitor may have a predetermined third capacitance. Further, the internal capacitor may be a variable capacitor, and the third capacitance may be adjusted in a range equal to or greater than the first capacitance. In this case, the monitoring circuit may monitor whether the battery is deformed based on the amount of change between a third frequency and a fourth frequency. Specifically, the third frequency corresponding to the first capacitance and the third capacitance formed at the first time point may be obtained by the monitoring circuit. Moreover, the fourth frequency corresponding to the second capacitance and the third capacitance formed at the second time point may be obtained by the monitoring circuit. Furthermore, whether the case is deformed may be monitored by the monitoring circuit based on the amount of change between the third frequency and the fourth frequency.

The flowchart of FIG. 11 and the foregoing description are merely examples of the present disclosure, and the scope of the present disclosure is not limited to the flowchart of FIG. 11 and the foregoing description. For example, one or more steps in the flowchart and the foregoing description may be added/modified/deleted, the order of one or more steps may be changed, and one or more steps may be performed simultaneously.

FIG. 12 is a flowchart showing an example of a method for determining whether a battery is deformed in accordance with at least one embodiment of the present disclosure. The battery monitoring device may determine whether the battery is deformed based on the amount of change in the resonant frequency generated in the monitoring circuit.

The method for determining whether a battery is deformed may begin with the battery monitoring device comparing a first frequency obtained by the monitoring circuit at a first time point with a second frequency obtained by the monitoring circuit at a second time point that is after the first time point.

In at least one embodiment, if the first frequency obtained at the first time point and the second frequency obtained at the second time point are the same, the battery monitoring device may determine that the battery is normal (S1210, S1270).

In contrast, if the first frequency obtained at the first time point and the second frequency obtained at the second time point are different from each other, the battery monitoring device may check whether the first frequency obtained at the first time point has a value greater than the second frequency obtained at the second time point (S1220). If the first frequency is greater than the second frequency, the battery monitoring device may check whether the difference between the first frequency and the second frequency has a value greater than a predetermined first threshold (S1230). At this time, if the difference between the first frequency and the second frequency has a value greater than the predetermined first threshold, the battery monitoring device may determine that the battery is swollen (S1240). In contrast, if the difference between the first frequency and the second frequency has a value less than or equal to the predetermined first threshold, the battery monitoring device may determine that the battery is normal (S1270).

Further, in the step of checking whether the first frequency obtained at the first time point has a value greater than the second frequency obtained at the second time point (S1220), if it is confirmed that the first frequency is less than the second frequency, the battery monitoring device may check whether the difference between the first frequency and the second frequency has a value greater than a predetermined second threshold (S1250). At this time, if the difference between the first frequency and the second frequency has a value greater than the predetermined second threshold, the battery monitoring device may determine that the battery is operating abnormally due to a factor other than battery swelling (S1260). In contrast, if the difference between the first frequency and the second frequency has a value less than or equal to the predetermined second threshold, the battery monitoring device may determine that the battery is normal (S1270).

The flowchart of FIG. 12 and the foregoing description are merely examples of the present disclosure, and the scope of the present disclosure is not limited to the flowchart of FIG. 12 and the foregoing description. For example, one or more steps in the flowchart and the foregoing description may be added/modified/deleted, the order of one or more steps may be changed, and one or more steps may be performed simultaneously.

Although the present disclosure has been described above with respect to embodiments thereof, the present disclosure is not limited thereto. Various modifications and variations can be made thereto by those skilled in the art within the scope of the appended claims.

### [DESCRIPTION OF SOME REFERENCE SYMBOLS]

10: Battery
100: Battery monitoring device
110: Case
120: Sensing member
122: Conductor
124: Dielectric
130: Monitoring circuit

## Claims

1. A battery (10) comprising:
a case (110) formed of a conductive material;
a sensing member (120) attached to one surface of the case (110) and comprising a conductor (122) formed of a conductive material and a dielectric (124) having at least a part thereof disposed between the case (110) and the conductor (122); and
a monitoring circuit (130) electrically connected to the conductor (122) and the case (110),
wherein the monitoring circuit (130) is configured to monitor whether the battery (10) is deformed based on an amount of change in a capacitance formed between the conductor (122) and the one surface of the case (110),
wherein the monitoring circuit comprises an inductor (632), and the inductor (632) and the sensing member are connected, and a resonant frequency corresponding to the capacitance is generated,
wherein the monitoring circuit further comprises a controller (636), and
wherein the controller (636) is configured to determine whether the battery is deformed based on an amount of change between a first frequency corresponding to a first capacitance formed at a first time point and a second frequency corresponding to a second capacitance formed at a second time point that occurs later than the first time point,
wherein the monitoring circuit further comprises an internal capacitor (638) connected in series with the sensing member, and
wherein the internal capacitor has a predetermined third capacitance, and
the monitoring circuit is configured to monitor whether the battery is deformed based on an amount of change between a third frequency corresponding to the first capacitance and the third capacitance formed at the first time point, and a fourth frequency corresponding to the second capacitance and the third capacitance formed at the second time point,
wherein the internal capacitor (638) is a variable capacitor, and
the third capacitance is adjusted to be equal to or greater than the first capacitance in real time.

2. The battery as claimed in claim 1, wherein the conductor (122) is formed of a material having elasticity, and
as the battery swells, an area of a surface of the conductor (122) facing the case (110) is configured to increase or a thickness of the dielectric (124) is configured to decrease.

3. The battery as claimed in claim 1 or claim 2, wherein the case (410) has a rectangular parallelepiped shape,
the conductor (422) extends in one direction on a side surface of the rectangular parallelepiped shape,
one end of the conductor (422) is disposed adjacent to an edge of the side surface, and
another end of the conductor (422) is disposed to face a center location of the side surface.

4. The battery as claimed in claim 1 or claim 2, wherein the case (510) has a cylindrical shape,
the conductor (522) extends in one direction on a circumferential surface of the cylindrical shape,
one end of the conductor (522) is disposed adjacent to an edge of the circumferential surface, and
another end of the conductor (522) is disposed to face a center location of the circumferential surface.

5. The battery as claimed in any preceding claim, wherein the dielectric (124) is an insulating film or an insulating tape, and
the conductor (122) is formed in the form of a metal pattern on the dielectric (124).

6. A method of monitoring a battery,
wherein the battery (10) comprises:
a case (110) formed of a conductive material;
a sensing member (120) attached to one surface of the case (110) and comprising a conductor formed of a conductive material and a dielectric having at least a part thereof disposed between the case and the conductor; and
a monitoring circuit (130) electrically connected to the conductor (122) and the case (110),
wherein the monitoring circuit comprises an inductor (632), and the inductor (632) and the sensing member are connected, and a resonant frequency corresponding to the capacitance is generated,
wherein the monitoring circuit further comprises an internal capacitor (638) connected in series with the sensing member, and
wherein the internal capacitor has a predetermined third capacitance, and
wherein the internal capacitor (638) is a variable capacitor, and
the method comprising:
obtaining, by the monitoring circuit, a first frequency corresponding to a first capacitance formed between the conductor and the one surface of the case (110) at a first time point (S1110);
obtaining, by the monitoring circuit, a second frequency corresponding to a second capacitance formed between the conductor and the one surface of the case at a second time point that occurs later than the first time point (S1120); and
monitoring, by the monitoring circuit, whether the battery is deformed based on an amount of change between the first frequency and the second frequency (S1130),
obtaining, by the monitoring circuit, a third frequency corresponding to the first capacitance and the third capacitance formed at the first time point;
obtaining, by the monitoring circuit, a fourth frequency corresponding to the second capacitance and the third capacitance formed at the second time point; and
monitoring, by the monitoring circuit, whether the battery is deformed based on an amount of change between the third frequency and the fourth frequency,
adjusting the third capacitance to be equal to or greater than the first capacitance in real time.

7. The method as claimed in claim 6, wherein the monitoring (S1130) comprises:
determining that the case is swollen if the second frequency is less than the first frequency and an amount of change between the first frequency and the second frequency is greater than a predetermined first threshold amount.

8. The method as claimed in claim 6 or claim 7, wherein the monitoring (S1130) comprises:
determining that the battery is operating abnormally if the second frequency is greater than the first frequency and an amount of change between the first frequency and the second frequency is greater than a predetermined second threshold amount.

9. The method as claimed in any of claims 6 to 8, wherein the conductor is formed of a material having elasticity, and
as the battery swells, an area of a surface of the conductor facing the case increases or a thickness of the dielectric decreases.

## Patentansprüche

1. Batterie (10), die Folgendes umfasst:
ein Gehäuse (110), das aus einem leitfähigen Material gebildet ist;
ein Abtastelement (120), das an einer Oberfläche des Gehäuses (110) angebracht ist, das einen Leiter (122) umfasst, der aus einem leitfähigen Material und einem Dielektrikum (124) gebildet ist, wobei mindestens ein Teil davon zwischen dem Gehäuse (110) und dem Leiter (122) angeordnet ist; und
eine Überwachungsschaltung (130), die elektrisch mit dem Leiter (122) und dem Gehäuse (110) verbunden ist,
wobei die Überwachungsschaltung (130) dazu konfiguriert ist, basierend auf einer Änderung einer Kapazität zwischen dem Leiter (122) und der einen Oberfläche des Gehäuses (110) zu überwachen, ob die Batterie (10) verformt ist,
wobei die Überwachungsschaltung eine Induktivität (632) umfasst und die Induktivität (632) und das Abtastelement miteinander verbunden sind und eine der Kapazität entsprechende Resonanzfrequenz erzeugt wird,
wobei die Überwachungsschaltung weiter eine Steuereinheit (636) umfasst, und
wobei die Steuereinheit (636) dazu konfiguriert ist, basierend auf einer Änderungsmenge zwischen einer ersten Frequenz, die einer ersten Kapazität entspricht, die zu einem ersten Zeitpunkt gebildet wird, und einer zweiten Frequenz, die einer zweiten Kapazität entspricht, die zu einem zweiten Zeitpunkt, der später als der erste Zeitpunkt auftritt, gebildet wird, zu bestimmen, ob die Batterie verformt ist,
wobei die Überwachungsschaltung weiter einen internen Kondensator (638) umfasst, der in Reihe mit dem Abtastelement geschaltet ist, und
wobei der interne Kondensator eine vorbestimmte dritte Kapazität aufweist, und
die Überwachungsschaltung dazu konfiguriert ist, basierend auf einer Änderungsmenge zwischen einer dritten Frequenz, die der ersten Kapazität und der dritten Kapazität entspricht, die zu dem ersten Zeitpunkt gebildet wird, und einer vierten Frequenz, die der zweiten Kapazität und der dritten Kapazität entspricht, die zu dem zweiten Zeitpunkt gebildet wird, zu überwachen, ob die Batterie verformt ist,
wobei der interne Kondensator (638) ein variabler Kondensator ist, und
die dritte Kapazität in Echtzeit eingestellt wird, um gleich oder größer als die erste Kapazität zu sein.

2. Batterie nach Anspruch 1, wobei der Leiter (122) aus einem Material, das Elastizität aufweist, gebildet ist, und
während sich die Batterie aufbläht, eine Fläche einer Oberfläche des Leiters (122), die dem Gehäuse (110) zugewandt ist, dazu konfiguriert ist, größer zu werden, oder eine Dicke des Dielektrikums (124) dazu konfiguriert ist, abzunehmen.

3. Batterie nach Anspruch 1 oder Anspruch 2, wobei das Gehäuse (410) eine Form eines rechteckigen Parallelepipeds aufweist,
sich der Leiter (422) in einer Richtung auf einer Seitenfläche der rechteckigen Parallelepipedform erstreckt,
ein Ende des Leiters (422) an eine Kante der Seitenfläche angrenzend angeordnet ist, und
ein anderes Ende des Leiters (422) dazu angeordnet ist, einer Mitte der Seitenfläche zugewandt zu sein.

4. Batterie nach Anspruch 1 oder Anspruch 2, wobei das Gehäuse (510) eine zylindrische Form aufweist,
sich der Leiter (522) in einer Richtung auf einer Umfangsfläche der zylindrischen Form erstreckt,
ein Ende des Leiters (522) an eine Kante der Umfangsfläche angrenzend angeordnet ist, und
ein anderes Ende des Leiters (522) dazu angeordnet ist, einer Mitte der Umfangsfläche zugewandt zu sein.

5. Batterie nach einem vorstehenden Anspruch, wobei das Dielektrikum (124) eine Isolierfolie oder ein Isolierband ist, und
der Leiter (122) in der Form einer Metallstruktur auf dem Dielektrikum (124) gebildet ist.

6. Verfahren zum Überwachen einer Batterie,
wobei die Batterie (10) Folgendes umfasst:
ein Gehäuse (110), das aus einem leitfähigen Material gebildet ist;
ein Abtastelement (120), das an einer Oberfläche des Gehäuses (110) angebracht ist und einen Leiter umfasst, der aus einem leitfähigen Material und einem Dielektrikum gebildet ist, von dem mindestens ein Teil zwischen dem Gehäuse und dem Leiter angeordnet ist; und
eine Überwachungsschaltung (130), die elektrisch mit dem Leiter (122) und dem Gehäuse (110) verbunden ist,
wobei die Überwachungsschaltung eine Induktivität (632) umfasst und die Induktivität (632) und das Abtastelement miteinander verbunden sind und eine der Kapazität entsprechende Resonanzfrequenz erzeugt wird,
wobei die Überwachungsschaltung weiter einen internen Kondensator (638) umfasst, der in Reihe mit dem Abtastelement geschaltet ist, und
wobei der interne Kondensator eine vorbestimmte dritte Kapazität aufweist, und
wobei der interne Kondensator (638) ein variabler Kondensator ist, und
wobei das Verfahren Folgendes umfasst:
Erhalten, durch die Überwachungsschaltung, einer ersten Frequenz, die einer ersten Kapazität entspricht, die zwischen dem Leiter und einer Oberfläche des Gehäuses (110) zu einem ersten Zeitpunkt (S1110) gebildet wird;
Erhalten, durch die Überwachungsschaltung, einer zweiten Frequenz, die einer zweiten Kapazität entspricht, die zwischen dem Leiter und der einen Oberfläche des Gehäuses zu einem zweiten Zeitpunkt gebildet wird, der später als der erste Zeitpunkt (S1120) auftritt; und
Überwachen, durch die Überwachungsschaltung, basierend auf einer Änderungsmenge zwischen der ersten Frequenz und der zweiten Frequenz (S1130), ob die Batterie verformt ist,
Erhalten, durch die Überwachungsschaltung, einer dritten Frequenz, die der ersten Kapazität und der dritten Kapazität entspricht, die zu dem ersten Zeitpunkt gebildet werden;
Erhalten, durch die Überwachungsschaltung, einer vierten Frequenz, die der zweiten Kapazität und der dritten Kapazität entspricht, die zu dem zweiten Zeitpunkt gebildet werden; und
Überwachen, durch die Überwachungsschaltung, basierend auf einer Änderungsmenge zwischen der dritten Frequenz und der vierten Frequenz, ob die Batterie verformt ist,
Einstellen der dritten Kapazität in Echtzeit, um gleich oder größer als die erste Kapazität zu sein.

7. Verfahren nach Anspruch 6, wobei das Überwachen (S1130) Folgendes umfasst:
Bestimmen, dass das Gehäuse aufgebläht ist, wenn die zweite Frequenz geringer als die erste Frequenz ist und eine Änderungsmenge zwischen der ersten und der zweiten Frequenz größer als eine vorbestimmte erste Schwellenmenge ist.

8. Verfahren nach Anspruch 6 oder Anspruch 7, wobei das Überwachen (S1130) Folgendes umfasst:
Bestimmen, dass die Batterie abnormal arbeitet, wenn die zweite Frequenz größer als die erste Frequenz ist und eine Änderungsmenge zwischen der ersten und der zweiten Frequenz größer als eine vorbestimmte zweite Änderungsmenge ist.

9. Verfahren nach einem der Ansprüche 6 bis 8, wobei der Leiter aus einem Material gebildet ist, das Elastizität aufweist, und
während sich die Batterie aufbläht, eine Fläche einer Oberfläche des Leiters, die dem Gehäuse zugewandt ist, zunimmt oder eine Dicke des Dielektrikums abnimmt.

## Revendications

1. Batterie (10) comprenant :
un boîtier (110) constitué d'un matériau conducteur ;
un élément de détection (120) fixé à une surface du boîtier (110) et comprenant un conducteur (122) constitué d'un matériau conducteur et un diélectrique (124) présentant au moins une partie de celui-ci disposée entre le boîtier (110) et le conducteur (122) ; et
un circuit de surveillance (130) connecté électriquement au conducteur (122) et au boîtier (110),
dans laquelle le circuit de surveillance (130) est configuré pour surveiller si la batterie (10) est déformée sur la base d'une quantité de changement d'une capacité formée entre le conducteur (122) et l'une surface du boîtier (110),
dans laquelle le circuit de surveillance comprend une inductance (632), et l'inductance (632) et l'élément de détection sont connectés, et une fréquence de résonance correspondant à la capacité est générée,
dans laquelle le circuit de surveillance comprend en outre un dispositif de commande (636), et
dans laquelle le dispositif de commande (636) est configuré pour déterminer si la batterie est déformée sur la base d'une quantité de changement entre une première fréquence correspondant à une première capacité formée à un premier instant et une deuxième fréquence correspondant à une deuxième capacité formée à un second instant qui survient plus tard que le premier instant,
dans laquelle le circuit de surveillance comprend en outre un condensateur interne (638) connecté en série avec l'élément de détection, et
dans laquelle le condensateur interne présente une troisième capacité prédéterminée, et
le circuit de surveillance est configuré pour surveiller si la batterie est déformée sur la base d'une quantité de changement entre une troisième fréquence correspondant à la première capacité et la troisième capacité formées au premier instant, et une quatrième fréquence correspondant à la deuxième capacité et à la troisième capacité formées au second instant,
dans laquelle le condensateur interne (638) est un condensateur variable, et
la troisième capacité est ajustée pour être égale ou supérieure à la première capacité en temps réel.

2. Batterie selon la revendication 1, dans laquelle le conducteur (122) est constitué d'un matériau présentant une élasticité, et
lorsque la batterie gonfle, une zone d'une surface du conducteur (122) faisant face au boîtier (110) est configurée pour augmenter ou une épaisseur du diélectrique (124) est configurée pour diminuer.

3. Batterie selon la revendication 1 ou la revendication 2, dans laquelle le boîtier (410) présente une forme de parallélépipède rectangle,
le conducteur (422) s'étend dans une direction sur une surface latérale de la forme de parallélépipède rectangle,
une extrémité du conducteur (422) est disposée à proximité d'un bord de la surface latérale, et
une autre extrémité du conducteur (422) est disposée pour faire face à un emplacement central de la surface latérale.

4. Batterie selon la revendication 1 ou la revendication 2, dans laquelle le boîtier (510) présente une forme cylindrique,
le conducteur (522) s'étend dans une direction sur une surface circonférentielle de la forme cylindrique,
une extrémité du conducteur (522) est disposée à proximité d'un bord de la surface circonférentielle, et
une autre extrémité du conducteur (522) est disposée de manière à faire face à un emplacement central de la surface circonférentielle.

5. Batterie selon une quelconque revendication précédente, dans laquelle le diélectrique (124) est un film isolant ou un ruban isolant, et
le conducteur (122) se présente sous la forme d'une impression métallique sur le diélectrique (124).

6. Procédé de surveillance d'une batterie,
dans lequel la batterie (10) comprend :
un boîtier (110) constitué d'un matériau conducteur ;
un élément de détection (120) fixé à une surface du boîtier (110) et comprenant un conducteur constitué d'un matériau conducteur et un diélectrique présentant au moins une partie de celui-ci disposée entre le boîtier et le conducteur ; et
un circuit de surveillance (130) connecté électriquement au conducteur (122) et au boîtier (110),
dans lequel le circuit de surveillance comprend une inductance (632), et l'inductance (632) et l'élément de détection sont connectés, et une fréquence de résonance correspondant à la capacité est générée,
dans lequel le circuit de surveillance comprend en outre un condensateur interne (638) connecté en série avec l'élément de détection, et
dans lequel le condensateur interne présente une troisième capacité prédéterminée, et
dans lequel le condensateur interne (638) est un condensateur variable, et
le procédé comprenant :
l'obtention, par le circuit de surveillance, d'une première fréquence correspondant à une première capacité formée entre le conducteur et l'une surface du boîtier (110) à un premier instant (S1110) ;
l'obtention, par le circuit de surveillance, d'une deuxième fréquence correspondant à une deuxième capacité formée entre le conducteur et l'une surface du boîtier à un second instant qui survient après le premier instant (S1120) ; et
la surveillance, par le circuit de surveillance, de la déformation de la batterie sur la base d'une quantité de changement entre la première fréquence et la deuxième fréquence (S1130),
l'obtention, par le circuit de surveillance, d'une troisième fréquence correspondant à la première capacité et à la troisième capacité formées au premier instant ;
l'obtention, par le circuit de surveillance, d'une quatrième fréquence correspondant à la deuxième capacité et à la troisième capacité formées au deuxième instant ; et
la surveillance, par le circuit de surveillance, de la déformation de la batterie sur la base d'une quantité de changement entre la troisième et la quatrième fréquence,
l'ajustement de la troisième capacité pour qu'elle soit égale ou supérieure à la première capacité en temps réel.

7. Procédé selon la revendication 6, dans lequel la surveillance (S1130) comprend :
la détermination que le boîtier est gonflé si la deuxième fréquence est inférieure à la première fréquence et qu'une quantité de changement entre la première fréquence et la deuxième fréquence est supérieure à une première quantité seuil prédéterminée.

8. Procédé selon la revendication 6 ou la revendication 7, dans lequel la surveillance (S1130) comprend :
la détermination que la batterie fonctionne anormalement si la deuxième fréquence est supérieure à la première fréquence et qu'une quantité de changement entre la première fréquence et la deuxième fréquence est supérieure à une seconde quantité seuil prédéterminée.

9. Procédé selon l'une quelconque des revendications 6 à 8, dans lequel le conducteur est constitué d'un matériau présentant une élasticité, et
lorsque la batterie gonfle, une zone d'une surface du conducteur faisant face au boîtier augmente ou une épaisseur du diélectrique diminue.
